# EUROPÄISCHE PATENTSCHRIFT

(11) **EP 3 729 113 B1**
(45) Veröffentlichungstag und Bekanntmachung des Hinweises auf die Patenterteilung: **09.06.2021**
(21) Anmeldenummer: 18803979.6
(22) Anmeldetag: 16.11.2018
(51) Int. Cl.: G01R 29/12

(54) **VORRICHTUNG ZUR MESSUNG EINES ELEKTRISCHEN FELDS**
DEVICE FOR MEASURING AN ELECTRIC FIELD
DISPOSITIF DE MESURE D'UN CHAMP ÉLECTRIQUE

(30) Priorität: 20.12.2017 AT 510522017
(43) Veröffentlichungstag der Anmeldung: 28.10.2020
(73) Patentinhaber: Donau-Universität Krems, 3500 Krems (AT)
(72) Erfinder: HORTSCHITZ, Wilfried, 7033 Pöttsching (AT); STIFTER, Michael, 2620 Neunkirchen (AT); STEINER, Harald, 2620 Flatz (AT)
(74) Vertreter: KLIMENT & HENHAPEL
(86) Internationale Anmeldenummer: PCT/EP2018/081516
(87) Internationale Veröffentlichungsnummer: WO 2019/120795

(56) Entgegenhaltungen:
- DE-A1-102012 222 973
- RU-C2- 2 212 678
- US-A1- 2015 070 028
- MA QING ET AL: "A MEMS-Based Electric Field Sensor for Measurement of High-Voltage DC Synthetic Fields in Air", IEEE SENSORS JOURNAL, IEEE SERVICE CENTER, NEW YORK, NY, US, Bd. 17, Nr. 23, 1. Dezember 2017 (2017-12-01), Seiten 7866-7876, XP011672989, ISSN: 1530-437X, DOI: 10.1109/JSEN.2017.2762327 [gefunden am 2017-11-09]

## Beschreibung

### GEBIET DER ERFINDUNG

Die vorliegende Erfindung betrifft eine Vorrichtung zur Messung eines elektrischen Felds, insbesondere eines statischen oder quasistatischen elektrischen Felds.

### STAND DER TECHNIK

Die Messung von elektrischen Feldern, insbesondere von statischen oder relativ langsam variierenden elektrischen Feldern, spielt in unterschiedlichsten Bereichen eine Rolle. Beispielsweise kann die Bestimmung von elektrischen Feldern bei Arbeitsplätzen in elektrostatisch geschützten Bereichen wie z.B. bei der Herstellung und Verpackung elektronischer Bauteile wichtig sein, wo Oberflächenladungen vermieden werden müssen. Ein gänzlich anderes Beispiel stellt die Messung von elektrischen Feldern in der Erdatmosphäre dar, was für die Meteorologie wichtige Informationen liefert, da Veränderungen dieser elektrischen Felder durch Wettererscheinungen wie z.B. Gewitter, Kalt-/Warmfrondurchgänge oder Regenwolken hervorgerufen werden. Insbesondere sei auch die Blitzforschung genannt, für die die Überwachung von elektrostatischen Feldern in der Atmosphäre von eminenter Bedeutung ist, beispielsweise um das Auftreten von Blitzen vorhersagen zu können.

Aus dem Stand der Technik sind zur Messung von elektrischen Feldern insbesondere Elektrofeldmeter bekannt, bei denen mittels eines sich drehenden Flügelrads periodisch eine elektrisch leitende Sensorelektrode freigegeben und wieder verdeckt wird, sodass sich die Sensorelektrode durch Influenz des externen elektrischen Felds abwechselnd auf- und entladen kann, siehe z.B. D.A. Hill und M. Kanda, The measurement, instrumentation, and sensors handbook XXV, section 47, Electric Field Strength (CRC Press LLC and IEEE Press, 1999). Aufgrund des Flügelrads werden Elektrofeldmeter häufig auch als Feldmühlen bezeichnet. Nachteilig an diesen Feldmühlen ist, dass diese üblicherweise relativ groß dimensioniert werden müssen und entsprechend unhandlich sind. Davon abgesehen ist selbst bei relativ klein dimensionierten Feldmühlen üblicherweise eine Erdung einzelner Teile der jeweiligen Feldmühle, insbesondere der Sensorelektrode, vorgesehen, was die zu messenden elektrischen Felder unweigerlich verzerrt.

Demgegenüber benötigen aus dem Stand der Technik bekannte elektrooptische Sensoren zur Messung von elektrischen Feldern keine Erdung und sind, was mögliche Verzerrungen des zu messenden elektrischen Felds betrifft, Feldmühlen überlegen, siehe z.B. N.J. Vasa et al., Journal of Materials Processing Technology 185 (1-3), 173 (April 2007). Beispielsweise kann mittels elektrooptischer Kristalle die elektrische Feldstärke anhand von Lichtabsorption oder Veränderungen des Brechungsindex bestimmt werden. Die bekannten elektrooptischen Sensoren weisen jedoch eine starke intrinsische Temperaturinstabilität auf, die auf den pyroelektrischen Effekt in Verbindung mit der thermischen Ausdehnung des jeweiligen Sensormaterials zurückzuführen ist.

Aus der DE 102012222973 A1 ist ein mikromechanisches Elektrofeldmeter als Gewitterwarner bekannt, welches ein Substrat, eine erste Elektrode, eine darüber angeordnete zweite Elektrode sowie eine Antriebsanordnung aufweist. Mittels der Antriebsanordnung werden die beiden Elektroden relativ zueinander periodisch ausgelenkt. Die zweite Elektrode weist ein definiertes Potential auf und schirmt somit die erste Elektrode gegenüber dem elektrischen Feld in Abhängigkeit von der vorherrschenden Auslenkung ab. Aufgrund der periodischen Auslenkung wird somit durch das elektrische Feld in der ersten Elektrode eine periodisch schwankende Spannung induziert, die entsprechend ausgewertet wird.

### AUFGABE DER ERFINDUNG

Es ist daher die Aufgabe der vorliegenden Erfindung, eine Vorrichtung zur Messung eines elektrischen Felds, insbesondere eines statischen oder zeitlich langsam variierenden elektrischen Felds, zur Verfügung zu stellen, welche die oben genannten Nachteile vermeidet. Insbesondere soll die erfindungsgemäße Vorrichtung das zu messende elektrische Feld nicht verzerren und soll die erfindungsgemäße Vorrichtung miniaturisierbar sowie möglichst temperaturunempfindlich bzw. temperaturstabil sein.

### DARSTELLUNG DER ERFINDUNG

Zur Lösung der genannten Aufgabe ist erfindungsgemäß eine Vorrichtung zur Messung eines elektrischen Felds vorgesehen, die Vorrichtung umfassend eine mikromechanische Struktur, welche sich in einer ersten Richtung, einer zweiten Richtung und einer dritten Richtung erstreckt, wobei die erste Richtung, die zweite Richtung und die dritte Richtung wechselseitig normal aufeinander stehen, wobei die mikromechanische Struktur aus einem bei einer Betriebstemperatur elektrisch leitenden Material gefertigt ist und einen Rahmenabschnitt sowie einen beweglichen Abschnitt aufweist, wobei der bewegliche Abschnitt mit dem Rahmenabschnitt elektrisch leitend und mechanisch elastisch verbunden ist und relativ zum Rahmenabschnitt bewegbar ist, wobei die mikromechanische Struktur so ausgelegt ist, dass bei einer Anordnung der mikromechanischen Struktur im elektrischen Feld mit einer ersten Feldstärkenkomponente parallel zur ersten Richtung ungleich null eine elektrische Polarisation der mikromechanischen Struktur erfolgt, die eine auf den beweglichen Abschnitt wirkende erste Kraftkomponente parallel zur ersten Richtung sowie eine von der ersten Kraftkomponente abhängige Änderung der räumlichen Anordnung des beweglichen Abschnitts relativ zum Rahmenabschnitt zur Folge hat, und wobei Detektionsmittel vorgesehen sind, um die Änderung der räumlichen Anordnung des beweglichen Abschnitts relativ zum Rahmenabschnitt zu bestimmen.

Mit dieser Vorrichtung lassen sich insbesondere statische elektrische Felder (d.h. mit Frequenz 0 Hz) bzw. quasistatische elektrische Felder (Frequenz typischerweise im Bereich von 100 Hz oder niedriger) bestimmen, wobei die maximale Frequenz der noch detektierbaren elektrischen Felder durch die mechanischen Eigenschaften der mikromechanischen Struktur, insbesondere durch deren Eigen- bzw. Resonanzfrequenzen bestimmt wird.

Eine Verzerrung des zu messenden elektrischen Felds wird durch die erfindungsgemäße Vorrichtung praktisch ausgeschlossen, insbesondere da die erfindungsgemäße Vorrichtung extrem kompakt gebaut werden kann (aufgrund der geringen Abmessungen wird das elektrische Feld praktisch nicht verzerrt) und da keinerlei Erdung notwendig ist.

Die thermische Abhängigkeit der mechanischen Eigenschaften der mikromechanischen Struktur ist wohldefiniert und bekannt, sodass zum einen eine systematische wohldefinierte Temperaturabhängigkeit gegeben ist, sodass diese leicht rechnerische berücksichtigt werden kann. Zum anderen kann die Temperaturabhängigkeit durch geeignete Materialwahl und eine optimierte Geometrie auch noch stark reduziert werden, weshalb die erfindungsgemäße Vorrichtung insbesondere im Vergleich mit dem bekannten Stand der Technik als temperaturunempfindlich bzw. temperaturstabil zu bezeichnen ist.

Die mikromechanische Struktur könnte auch als Sensor bezeichnet werden, der mit den Detektionsmitteln ausgelesen wird.

Typischerweise liegen die Abmessungen der mikromechanischen Struktur in der ersten und zweiten Richtung im Bereich von 0,1 mm bis 5 mm, vorzugsweise von 0,1 mm bis 1 mm, und in der dritten Richtung typischerweise um zumindest eine Größenordnung weniger. Typischerweise liegt dann die oben erwähnte maximale Frequenz von noch detektierbaren elektrischen Feldern entsprechend im Bereich von 10 kHz. Im Rahmen der vorliegenden Anmeldung ist der Begriff "mikromechanische Struktur" jedoch so zu verstehen, dass theoretisch auch Abmessungen im Sub-Mikrometerbereich möglich sind, insbesondere in der dritten Richtung. Die erfindungsgemäße Vorrichtung ist somit nicht nur stark miniaturisierbar, sondern es kann besagte maximale Frequenz auch noch deutlich über die genannten 10 kHz erhöht werden.

Die Betriebstemperatur bezeichnet jene Temperatur, bei der die Vorrichtung typischerweise eingesetzt wird. Die Betriebstemperatur ist üblicherweise deutlich höher als der absolute Nullpunkt, sodass typischerweise auch Halbleitermaterialien für die mikromechanische Struktur in Frage kommen, da diese bei der Betriebstemperatur hinreichend leitend sind. Letzteres bedeutet, dass bei der Betriebstemperatur die mikromechanische Struktur durch elektrische Influenz sehr rasch polarisierbar ist, da die Ladungsträger im Material der mikromechanischen Struktur wandern können.

Die elektrisch leitende Verbindung zwischen dem Rahmenabschnitt und dem beweglichen Abschnitt stellt sicher, dass tatsächlich die mikromechanische Struktur als gesamtes polarisiert wird und nicht der Rahmenabschnitt und der bewegliche Abschnitt separat.

Die mechanisch elastische Verbindung zwischen dem Rahmenabschnitt und dem beweglichen Abschnitt stellt sicher, dass sich der bewegliche Abschnitt bei Vorhandensein eines elektrischen Felds gegenüber dem Rahmenabschnitt bewegen kann und wieder seine ursprüngliche räumliche Anordnung relativ zum Rahmenabschnitt annimmt, wenn das elektrische Feld nicht mehr vorhanden ist. D.h. die mechanisch elastische Verbindung ist gleichbedeutend mit einer Verbindung mittels Federelementen bzw. federnden Elementen. Derlei Verbindungen sind an sich bekannt. Sie können insbesondere durch geeignete Materialwahl der Verbindung zwischen dem beweglichen Abschnitt und dem Rahmenabschnitt realisiert werden.

Vorzugsweise ist der bewegliche Abschnitt zumindest parallel zur ersten Richtung bewegbar. In diesem Fall kann ein elektrisches Feld in der ersten Richtung bzw. die erste Feldstärkenkomponente ungleich null eine erste Kraftkomponente und folglich eine Auslenkung bzw. Änderung der Anordnung des beweglichen Abschnitts relativ zum Rahmenabschnitt parallel zur ersten Richtung bewirken bzw. hervorrufen. Die Auslenkung bzw. Größe der Anordnungsänderung, welche mittels der Detektionsmittel bestimmt wird, ist dann entsprechend ein Maß für die elektrische Feldstärke in der ersten Richtung bzw. für die erste Feldstärkenkomponente.

Selbstverständlich kann bei der erfindungsgemäßen Vorrichtung auch eine Steuereinheit vorgesehen sein, um sofort eine "Umrechnung" zwischen der bestimmten Anordnungsänderung und der Größe des elektrischen Felds in der ersten Richtung bzw. der ersten Feldstärkenkomponente vorzunehmen.

Eine vollständige räumliche Auflösung, d.h. in allen drei Raumrichtungen, eines beliebig orientierten elektrischen Felds lässt sich entsprechend realisieren, indem z.B. drei erfindungsgemäße Vorrichtungen folgendermaßen kombiniert werden: Der bewegliche Abschnitt der ersten Vorrichtung lässt sich gezielt nur in der ersten Richtung bewegen, der bewegliche Abschnitt der zweiten Vorrichtung nur in der zweiten Richtung und der bewegliche Abschnitt der dritten Vorrichtung nur in der dritten Richtung. "Nur" ist dabei so zu verstehen, dass Bewegungen des jeweiligen beweglichen Abschnitts in den anderen beiden Richtungen zwar prinzipiell nicht ausgeschlossen werden können, doch um zumindest eine Größenordnung geringer ausfallen, wenn eine gleich große Feldstärkenkomponente in diesen Richtungen vorliegt. Mit anderen Worten ist die mechanisch elastische Verbindung derart, dass zumindest näherungsweise in einer der drei Richtungen eine Federkonstante gegeben ist, die um zumindest eine Größenordnung kleiner ist als die Federkonstante in den restlichen zwei Richtungen.

Im einfachsten Fall werden einfach drei gleiche Vorrichtungen derart kombiniert, dass die erste Vorrichtung entlang der ersten Richtung orientiert ist, die zweite Vorrichtung entlang der zweiten Richtung und die dritte Vorrichtung entlang der dritten Richtung.

Analog zum oben Gesagten kann eine Steuereinheit vorgesehen sein, die sofort die für alle drei Richtungen bestimmten Anordnungsänderungen in die Größe des elektrischen Felds in allen drei Richtungen bzw. in die Größe der ersten Feldstärkenkomponente, einer zweiten Feldstärkenkomponente und einer dritten Feldstärkenkomponente umrechnet.

Um die mikromechanische Struktur, insbesondere mit den federnden Elementen zwischen dem beweglichen Abschnitt und dem Rahmenabschnitt, wohldefiniert mit gewünschten mechanischen Eigenschaften herstellen zu können, können der Rahmenabschnitt und der bewegliche Abschnitt, insbesondere die gesamte mikromechanische Struktur, einstückig ausgebildet sein. Dabei können der Rahmenabschnitt und der bewegliche Abschnitt, insbesondere die gesamte mikromechanische Struktur aus, vorzugsweise einkristallinem, Silizium gefertigt sein. Dies ermöglicht beispielsweise die Herstellung auf Basis eines Silizium-Wafers oder Silicon-On-Insulator (SOI)-Wafers in an sich bekannter Weise. Hierdurch ist außerdem eine kostengünstige Herstellung in großer Stückzahl möglich.

Um einen einfachen Aufbau zu gewährleisten, ist es bei einer bevorzugten Ausführungsform der erfindungsgemäßen Vorrichtung vorgesehen, dass der Rahmenabschnitt in einer Ebene, die parallel zur ersten Richtung und der zweiten Richtung ist, zumindest abschnittsweise im Wesentlichen eine U-Form ausbildet, wobei parallele Schenkel der U-Form parallel zur ersten Richtung verlaufen, dass der bewegliche Abschnitt zwischen den Schenkeln angeordnet ist und dass der bewegliche Abschnitt über Stege , die vorzugsweise parallel zur zweiten Richtung verlaufen, mit den Schenkeln verbunden ist.

Die Stege können dabei U-förmig oder mäanderförmig in der Ebene verlaufen, um mechanische Nichtlinearitäten bei größeren Auslenkungen / Anordnungsänderungen zu vermeiden.

Insbesondere lässt sich mit diesem Aufbau eine spezifische Sensitivität der erfindungsgemäßen Vorrichtung in der ersten Richtung erreichen, indem sich der bewegliche Abschnitt mechanisch leichter und ggf. auch weiter in der ersten Richtung bewegen lässt als in den anderen beiden Richtungen. Die Stege stellen in diesem Fall eine Federkonstante in der ersten Richtung sicher, die um zumindest eine Größenordnung kleiner ist als entsprechende Federkonstanten in den anderen beiden Richtungen.

Wie bereits oben gesagt, lassen sich drei gleiche solche Vorrichtungen kombinieren, um eine räumlich vollständige Auflösung des zu messenden elektrischen Felds zu ermöglichen.

Um die Empfindlichkeit bzw. das Auflösungsvermögen zu erhöhen, ist es bei einer bevorzugten Ausführungsform der erfindungsgemäßen Vorrichtung vorgesehen, dass die mikromechanische Struktur ein vom Rahmenabschnitt und vom beweglichen Abschnitt elektrisch separates Verstärkungselement umfasst, welches in der ersten Richtung gesehen hinter dem beweglichen Abschnitt angeordnet ist, wobei zwischen dem beweglichen Abschnitt und dem Verstärkungselement ein Spalt angeordnet ist. Das Verstärkungselement wird ebenfalls polarisiert, ohne dass die Ladungsträger vom Verstärkungselement zum Rahmenabschnitt oder gar beweglichen Abschnitt abfließen könnten. Der bewegliche Abschnitt hat daher im Bereich des Spalts eine genau entgegengesetzte Polarisation wie das Verstärkungselement im Bereich des Spalts. Entsprechend wird der bewegliche Abschnitt verstärkt zum Verstärkungselement gezogen bzw. bewirkt das Verstärkungselement eine Verstärkung der ersten Kraftkomponente, insbesondere in jenem räumlichen Bereich, wo der Spalt eine besonders geringe Spaltbreite aufweist, wobei letztere in der ersten Richtung gemessen wird.

Um die Verstärkung zu optimieren, ist es bei einer besonders bevorzugten Ausführungsform der erfindungsgemäßen Vorrichtung vorgesehen, dass der Spalt eine in der ersten Richtung gemessene Spaltbreite kleiner gleich 500 µm, bevorzugt kleiner gleich 200 µm, besonders bevorzugt von 0,1 µm bis 50 µm, aufweist. Letzteres gewährleistet gleichzeitig eine unkomplizierte Herstellung. Zum Vergleich: die zu detektierenden Auslenkungen/Anordnungsänderungen, die durch ein elektrisches Feld hervorgerufen werden, sind typischerweise kleiner als 1 µm.

Auf diese Weise lässt sich prinzipiell eine Auflösung im Bereich von 1 (V/m) / (Hz) ^{0,5} bis 50 (V/m) / (Hz) ^{0,5} erzielen.

Theoretisch sind unterschiedlichste Detektionsmittel denkbar, beispielsweise kapazitive oder akustische. Um eine Verzerrung des zu messenden elektrischen Felds durch die Detektion der Anordnungsänderung bzw. durch die Detektionsmittel auszuschließen und gleichzeitig eine größtmögliche Genauigkeit der Detektion sicherzustellen, ist es bei einer besonders bevorzugten Ausführungsform der erfindungsgemäßen Vorrichtung vorgesehen, dass die Detektionsmittel einen optischen Sensor sowie mindestens ein Lichtzuführmittel umfassen, um eine rein optische Detektion zu ermöglichen.

Theoretisch wäre es denkbar, mit dem optischen Sensor den beweglichen Abschnitt "direkt" abzubilden, sofern dieser groß genug ist bzw. der Sensor örtlich fein genug auflöst.

Geeignete optische Sensoren sind an sich bekannt. Denkbar wäre beispielsweise ein optischer Sensor auf Basis von mindestens einer Photodiode oder von mindestens einem Phototransistor. Dabei kann die mindestens eine Photodiode / der mindestens eine Phototransistor "direkt" beleuchtet werden, indem sie/er in räumlicher Nähe zum beweglichen Abschnitt, insbesondere unmittelbar unter dem beweglichen Abschnitt, angeordnet ist und das aus dem Bereich des beweglichen Abschnitts kommende Licht direkt einfängt. Oder die mindestens eine Photodiode / der mindestens eine Phototransistor wird "indirekt" beleuchtet, indem der optische Sensor mindestens ein Lichtleitmittel, insbesondere mindestens ein Glasfaserkabel, umfasst, um das Licht aus dem Bereich des beweglichen Abschnitts, insbesondere aus dem Bereich unmittelbar unter dem beweglichen Abschnitt, der mindestens einen Photodiode / dem mindestens einen Phototransistor zuzuleiten.

Das mindestens eine Lichtzuführmittel ist vorgesehen, um eine definierte Beleuchtung des beweglichen Abschnitts sicherzustellen. Das mindestens eine Lichtzuführmittel kann z.B. einen oder mehrere Lichtleiter umfassen und/oder mindestens ein Leuchtmittel, insbesondere eine oder mehrere Leuchtdioden.

Die mikromechanische Struktur muss nicht zwangsläufig zwischen dem mindestens einen Lichtzuführmittel und dem optischen Sensor angeordnet sein. Es wäre theoretisch z.B. auch eine Messung in Reflexionsgeometrie denkbar, bei der das mindestens eine Lichtzuführmittel und der optische Sensor bezogen auf die mikromechanische Struktur auf derselben Seite angeordnet sind.

Bei einer besonders bevorzugten Ausführungsform der erfindungsgemäßen Vorrichtung ist vorgesehen, dass der bewegliche Abschnitt zwischen dem mindestens einen Lichtzuführmittel und dem optischen Sensor angeordnet ist. Dies stellt eine konstruktiv besonders einfache Ausführungsform dar und ermöglicht es, zur Bestimmung der Auslenkung/Anordnungsänderung des beweglichen Abschnitts eine hierdurch geänderte Lichtmodulation und/oder eine hierdurch geänderte Transmission heranzuziehen.

Eine konstruktiv besonders einfache und kompakte Ausführung ergibt sich, indem der bewegliche Abschnitt zwischen mindestens einer Leuchtdiode und mindestens einer Photodiode bzw. mindestens einem Phototransistor angeordnet ist. Da diese Elemente jedoch mit Strom versorgt werden müssen, kann es Situationen geben, wo der Betrieb dieser Elemente nahe beim beweglichen Abschnitt das zu messende schwaches elektrische Feld zu stark beeinflussen und das Messergebnis zu stark verfälschen würde. Daher ist es bei einer besonders bevorzugten Ausführungsform der erfindungsgemäßen Vorrichtung vorgesehen, dass das mindestens eine Lichtzuführmittel einen Lichtleiter umfasst, um eine Seite der mikromechanischen Struktur zumindest abschnittsweise mit durch den Lichtleiter geleiteten Licht zu beleuchten, und dass der optische Sensor einen weiteren Lichtleiter umfasst, um das Licht auf einer gegenüberliegenden Seite der mikromechanischen Struktur aufzufangen.

Um eine besonders hohe Genauigkeit bei der Detektion der Auslenkung/Anordnungsänderung des beweglichen Abschnitts zu erzielen, ist es bei einer bevorzugten Ausführungsform der erfindungsgemäßen Vorrichtung vorgesehen, dass die Detektionsmittel eine Blendenstruktur am beweglichen Abschnitt sowie eine fixe Blendenstruktur umfassen, wobei die fixe Blendenstruktur eine relativ zum Rahmenabschnitt fixe räumliche Anordnung aufweist. Durch die fixe Blendenstruktur, die über - oder aber auch unter - der Blendenstruktur am beweglichen Abschnitt angeordnet ist, wird einfallendes Licht räumlich moduliert, bevor es auf den beweglichen Abschnitt fällt. Im Prinzip kann eine Auswertung der räumlich aufgelöst gemessenen Lichtmodulation bzw. deren Änderung zur Bestimmung der Auslenkung/Anordnungsänderung des beweglichen Abschnitts erfolgen.

Indem die Blendenstruktur am beweglichen Abschnitt zur fixen Blendenstruktur korrespondierende gewählt und angeordnet wird, bewegt sich diese Blendenstruktur mit dem beweglichen Abschnitt mit und können sich geringfügige Auslenkungen/Anordnungsänderungen des beweglichen Abschnitts in großen Änderungen der transmittierten Lichtintensität niederschlagen. Mit anderen Worten kann die Auslenkung/Anordnungsänderung hochgenau und gleichzeitig kostengünstig durch eine einfache Messung der transmittierten Lichtintensität erzielt werden, wofür z.B. ein(e) einfache(r), nicht ortsauflösende(r) Photodiode/Phototransistor genügt.

Um die fixe Blendenstruktur herstellungstechnisch besonders einfach herstellen zu können, ist es bei einer bevorzugten Ausführungsform der erfindungsgemäßen Vorrichtung vorgesehen, dass die fixe Blendenstruktur in einer Metallschicht auf einem Glas-Wafer ausgebildet ist. D.h. die Metallschicht bildet die fixe Blendenstruktur auf dem Glas-Wafer aus, der über dem beweglichen Abschnitt und räumlich fix zum Rahmenabschnitt angeordnet ist. Beispielsweise kann der Glas-Wafer mit dem Rahmenabschnitt mechanisch starr verbunden sein.

Eine Abstimmung der fixen Blendenstruktur auf die Blendenstruktur am beweglichen Abschnitt kann somit herstellungstechnisch sehr leicht vorgenommen werden. Beispielsweise kann die Blendenstruktur am beweglichen Abschnitt aus einer Vielzahl von rechteckigen Löchern bestehen, die entlang der ersten Richtung hintereinander angeordnet sind, wobei jedes Loch entlang der ersten Richtung eine geringere Ausdehnung hat als entlang der zweiten Richtung. Die korrespondierende fixe Blendenstruktur kann dann z.B. ebenfalls aus gleich großen und gleich angeordneten rechteckigen Löchern in der Metallschicht bestehen. Oder die korrespondierende fixe Blendenstruktur besteht z.B. aus rechteckigen Metallstreifen, die gleich groß wie die rechteckigen Löcher und gleich wie diese angeordnet sind, sodass sie bei einer bestimmten Auslenkung des beweglichen Abschnitts deckungsgleich mit den Löchern der Blendenstruktur am beweglichen Abschnitt sind und praktisch kein Licht transmittiert wird. Bei anderen Auslenkungen wird hingegen Licht in unterschiedlicher Intensität durch die fixe Blendenstruktur und die Blendenstruktur am beweglichen Abschnitt transmittiert.

Ein geeignetes Metall wäre z.B. Cr, welches auf den Glas-Wafer mittels Photolithographie und physikalischer Gasphasenabscheidung ("physical vapour deposition") aufgebracht werden kann.

Entsprechend dem oben Gesagten ist es bei einer besonders bevorzugten Ausführungsform der erfindungsgemäßen Vorrichtung vorgesehen, dass die fixe Blendenstruktur zwischen dem beweglichen Abschnitt, insbesondere der Blendenstruktur am beweglichen Abschnitt, und dem mindestens einen Lichtzuführmittel oder dem optischen Sensor angeordnet ist. Eine sehr kompakte Ausführung der erfindungsgemäßen Vorrichtung wird hierdurch ermöglicht.

Sofern die erfindungsgemäße Vorrichtung mechanischen Vibrationen ausgesetzt wird, besteht die Gefahr, dass es zu einer Auslenkung/Anordnungsänderung des beweglichen Abschnitts kommt, die nicht auf das Vorhandensein eines elektrischen Felds zurückgeht. Bzw. besteht dann die Gefahr, dass das Messergebnis betreffend ein vorhandenes elektrisches Feld entsprechend verfälscht wird. Um Auslenkungen/Anordnungsänderungen des beweglichen Abschnitts, die von Vibrationen hervorgerufen werden, von solchen, die durch elektrische Felder hervorgerufen werden, trennen bzw. unterscheiden zu können, ist es bei einer bevorzugten Ausführungsform der erfindungsgemäßen Vorrichtung vorgesehen, dass die mikromechanische Struktur so ausgelegt ist, dass die Änderung der räumlichen Anordnung des beweglichen Abschnitts relativ zum Rahmenabschnitt eine Rotation des beweglichen Abschnitts relativ zum Rahmenabschnitt, vorzugsweise um eine zur dritten Richtung parallele Rotationsachse, umfasst. Dies trägt dem Umstand Rechnung, dass Vibrationen üblicherweise lediglich translatorisch wirken und entsprechend lediglich lineare Auslenkungen/Anordnungsänderungen des beweglichen Abschnitts zur Folge haben. Indem gezielt der rotatorische Anteil der Auslenkungen/Anordnungsänderungen bestimmt wird, kann somit unmittelbar auf das elektrische Feld geschlossen werden.

Die entsprechende Auslegung kann durch eine geeignete, insbesondere asymmetrische mechanisch elastische Anbindung des beweglichen Abschnitts an den Rahmenabschnitt erfolgen.

Weiters kann der rotatorische Effekt des elektrischen Felds durch eine gezielte geometrische Ausgestaltung des Verstärkungselements verstärkt werden.

Alternativ oder zusätzlich dazu ist es zur Unterscheidung von Auslenkungen/Anordnungsänderungen des beweglichen Abschnitts, die von Vibrationen hervorgerufen werden, von solchen, die durch elektrische Felder hervorgerufen werden, bei einer bevorzugten Ausführungsform der erfindungsgemäßen Vorrichtung vorgesehen, dass die mikromechanische Struktur einen weiteren beweglichen Abschnitt umfasst, der mit dem Rahmenabschnitt elektrisch leitend und mechanisch elastisch verbunden ist, wobei die Stärke der mechanischen Ankopplung des weiteren beweglichen Abschnitts an den Rahmenabschnitt in einem bestimmten bekannten Verhältnis, vorzugsweise im Verhältnis 1:1, zur Stärke der mechanischen Ankopplung des beweglichen Abschnitts an den Rahmenabschnitt steht, und wobei die mikromechanische Struktur so ausgelegt ist, dass bei einer Anordnung der mikromechanischen Struktur im elektrischen Feld mit der ersten Feldstärkenkomponente ungleich null die elektrische Polarisation der mikromechanischen Struktur erfolgt, die eine auf den weiteren beweglichen Abschnitt wirkende weitere erste Kraftkomponente parallel zur ersten Richtung sowie eine von der weiteren ersten Kraftkomponente abhängige Änderung der räumlichen Anordnung des weiteren beweglichen Abschnitts relativ zum Rahmenabschnitt zur Folge hat, wobei die weitere erste Kraftkomponente und/oder die Änderung der räumlichen Anordnung des weiteren beweglichen Abschnitts um einen Faktor kleiner gleich 0,1, vorzugsweise kleiner gleich 0,01, kleiner ist als die erste Kraftkomponente und/oder die von der ersten Kraftkomponente hervorgerufene Änderung der räumlichen Anordnung des beweglichen Abschnitts, und dass weitere Detektionsmittel vorgesehen sind, um die Änderung der räumlichen Anordnung des weiteren beweglichen Abschnitts relativ zum Rahmenabschnitt zu bestimmen.

Auf den beweglichen Abschnitt und den weiteren beweglichen Abschnitt wirken die Vibrationen gleichermaßen. Das elektrische Feld wirkt sich jedoch um mindestens eine Größenordnung stärker auf den beweglichen Abschnitt als auf den weiteren beweglichen Abschnitt aus. Indem von der Auslenkung/Anordnungsänderung des beweglichen Abschnitts jene des weiteren beweglichen Abschnitts - ggf. unter Anwendung eines geeigneten Proportionalitätsfaktors, der dem Verhältnis der mechanischen Ankopplungen Rechnung trägt - abgezogen wird, erhält man im Wesentlichen jene Auslenkung/Anordnungsänderung des beweglichen Abschnitts, die vornehmlich auf das elektrische Feld zurückzuführen ist.

Herstellungstechnisch lässt sich diese Ausführungsvariante leicht realisieren, indem der weitere bewegliche Abschnitt und dessen Anbindung an den Rahmenabschnitt dem beweglichen Abschnitt und dessen Anbindung an den Rahmenabschnitt exakt gleich nachgebildet sind. Der Proportionalitätsfaktor kann somit entsprechend dem 1:1-Verhältnis der mechanischen Ankopplungen als genau 1 angenommen werden. Wenn dabei der weitere bewegliche Abschnitt räumlich zentral im Rahmenabschnitt angeordnet ist und der bewegliche Abschnitt am Rand des Rahmenabschnitts, wirkt auf den beweglichen Abschnitt zwangsläufig eine größere durch die elektrische Polarisation hervorgerufene Kraftkomponente als auf den weiteren beweglichen Abschnitt. Dieser Unterschied lässt sich außerdem nochmals deutlich verstärken, indem das Verstärkungselement in unmittelbarer Nachbarschaft zum beweglichen Abschnitt (von diesem nur durch den Spalt getrennt) angeordnet wird.

Die Detektion der Auslenkung/Anordnungsänderung des weiteren beweglichen Abschnitts kann genau gleich wie für den beweglichen Abschnitt erfolgen, sodass an dieser Stelle auf eine detaillierte Beschreibung verzichtet und stattdessen auf die entsprechenden, oben angeführten detaillierten Erläuterungen im Zusammenhang mit dem beweglichen Abschnitt verwiesen werden kann. D.h. für die weiteren Detektionsmittel gilt analog das zu den Detektionsmitteln Gesagte. Entsprechend ist es bei einer besonders bevorzugten Ausführungsform der erfindungsgemäßen Vorrichtung vorgesehen, dass die weiteren Detektionsmittel eine weitere Blendenstruktur am weiteren beweglichen Abschnitt sowie eine weitere fixe Blendenstruktur umfassen, wobei die weitere fixe Blendenstruktur eine relativ zum Rahmenabschnitt fixe räumliche Anordnung aufweist. Die weitere Blendenstruktur wird somit mit dem weiteren beweglichen Abschnitt mitbewegt. Die weitere fixe Blendenstruktur kann speziell auf die weitere Blendenstruktur abgestimmt sein, um eine hohe Genauigkeit der Bestimmung der Auslenkung/Anordnungsänderung des weiteren beweglichen Abschnitts zu ermöglichen, insbesondere durch einfache Lichttransmissionsmessungen. Vorzugsweise ist daher die weitere fixe Blendenstruktur über der weiteren Blendenstruktur angeordnet.

Ebenso ist es bei einer besonders bevorzugten Ausführungsform der erfindungsgemäßen Vorrichtung vorgesehen, dass die weiteren Detektionsmittel einen weiteren optischen Sensor sowie mindestens ein weiteres Lichtzuführmittel umfassen. Wiederum gilt analog das oben zum mindestens einen Lichtzuführmittel sowie zum optischen Sensor Gesagte.

Weiters ist es bei einer besonders bevorzugten Ausführungsform der erfindungsgemäßen Vorrichtung vorgesehen, dass der weitere optische Sensor durch den optischen Sensor und das mindestens eine weitere Lichtzuführmittel durch das mindestens eine Lichtzuführmittel ausgebildet sind, wobei der weitere bewegliche Abschnitt zwischen dem mindestens einen Lichtzuführmittel und dem optischen Sensor angeordnet ist. Insbesondere kann also der weitere bewegliche Abschnitt mit derselben Leuchtdiode beleuchtet werden wie der bewegliche Abschnitt. Der optische Sensor wiederum benötigt lediglich eine grobe örtliche Auflösung, gewissermaßen zwei große Pixel, um zwischen der durch den beweglichen Abschnitt transmittierten Lichtintensität und der durch den weiteren beweglichen Abschnitt transmittierten Lichtintensität unterscheiden zu können.

Besonders einfach lässt sich die weitere fixe Blendenstruktur realisieren, indem diese gemeinsam mit der fixen Blendenstruktur auf dem Glas-Wafer hergestellt wird bzw. angeordnet ist. Entsprechend ist es bei einer besonders bevorzugten Ausführungsform der erfindungsgemäßen Vorrichtung vorgesehen, dass die weitere fixe Blendenstruktur in der Metallschicht auf dem Glas-Wafer ausgebildet ist. D.h. auch die weitere fixe Blendenstruktur ist durch die Metallschicht ausgebildet. Der Glas-Wafer ist auch über dem weiteren beweglichen Abschnitt und räumlich fix zum Rahmenabschnitt angeordnet.

Das Einsatzgebiet der erfindungsgemäßen Vorrichtung ist mannigfaltig. Insbesondere ist erfindungsgemäß ein Fahrzeug, bevorzugt Luftfahrzeug, besonders bevorzugt unbemanntes Luftfahrzeug umfassend eine erfindungsgemäße Vorrichtung vorgesehen. Beispielsweise kann es sich bei dem Fahrzeug um eine Drohne, insbesondere Flugdrohne, handeln. Aber auch bei allen anderen Arten von Fahrzeugen kann die erfindungsgemäße Vorrichtung sinnvoll sein, um einem das Fahrzeug steuernden Menschen oder Computer Informationen über das das Fahrzeug umgebende elektrische Feld zu geben, sodass der Mensch/Computer das Fahrzeug in Abhängigkeit davon steuern kann. Dies ermöglicht es beispielsweise, einem zu hohen elektrischen Feld (hervorgerufen z.B. durch eine Starkstromleitung) mit dem Fahrzeug nicht zu nahe zu kommen und so eine Beschädigung des Fahrzeugs zu vermeiden. Z.B. kann eine Flugdrohne auf diese Weise eine 220 kV-Starkstromleitung (Frequenz des Wechselstroms: 50 Hz) auf ca. 70 m Entfernung berührungsfrei detektieren und einen entsprechenden Sicherheitsabstand einhalten.

Eine Vielzahl von weiteren Anwendungsbeispielen findet sich im Bereich des Arbeitsschutzes. Zur Warnung eines Arbeiters vor spannungsführenden Bauteilen ist erfindungsgemäß ein Schutzhelm umfassend eine erfindungsgemäße Vorrichtung vorgesehen. Die erfindungsgemäße Vorrichtung kann dabei fix in den Schutzhelm integriert sein.

Es wäre aber auch denkbar, dass die erfindungsgemäße Vorrichtung zur Montage auf einem Helm eingerichtet ist, um den erfindungsgemäßen Schutzhelm mittels eines konventionellen Helms auf einfache Art und Weise zu verwirklichen. Dies hat den Vorteil, dass im Prinzip ein beliebiger Helm verwendet werden kann und der Helm bei Bedarf auch ausgetauscht werden kann.

Beispielsweise kann zu diesem Zweck die mikromechanische Struktur in einem Sensormodul angeordnet sein. Das Sensormodul kann an die Form des Helms angepasst sein, um z.B. formschlüssig mit einem Abschnitt des Helms an diesem angeordnet zu werden. Besagter Abschnitt kann insbesondere vorne am Helm angeordnet sein, d.h. in einem Bereich, der beim Tragen des Helms nahe der Stirn des Benutzers angeordnet ist. Das Sensormodul kann über ein, insbesondere elastisches, Band mit einem Optoelektronikmodul verbunden sein, sodass das Sensormodul gemeinsam mit dem Optoelektronikmodul und dem Band über den Helm gestülpt oder gespannt werden kann, um am Helm befestigt zu werden. Das Band kann dabei Lichtzuführmittel und Lichtleitmittel, beispielsweise in Form von mindestens einer Glasfaser, aufweisen. Hiermit kann Licht, das im Optoelektronikmodul (beispielsweise mittels einer Leucht- oder Laserdiode) erzeugt wird, der mikromechanischen Struktur auf einer Seite zugeführt werden. Weiters können die Lichtleitmittel Teil eines optischen Sensors sein und Licht auf der gegenüberliegenden Seite der mikromechanischen Struktur auffangen und z.B. einer Photodiode des optischen Sensors zuführen, die im Optoelektronikmodul angeordnet ist. Das Optoelektronikmodul weist typischerweise eine entsprechende Auswerteelektronik auf, um die Sensordaten auszuwerten. Bei Detektion eines elektrischen Felds, das für den Arbeiter bzw. Benutzer gefährlich sein kann, kann das Optoelektronikmodul optische und/oder akustische Warnsignale ausgeben, um den Arbeiter bzw. Benutzer zu warnen.

Analog ist zur Warnung eines Arbeiters vor spannungsführenden Bauteilen erfindungsgemäß ein Schutzhandschuh umfassend eine erfindungsgemäße Vorrichtung vorgesehen.

Analog ist zur Warnung eines Arbeiters vor spannungsführenden Bauteilen erfindungsgemäß ein Schutzstiefel umfassend eine erfindungsgemäße Vorrichtung vorgesehen.

Analog ist zur Warnung eines Arbeiters vor spannungsführenden Bauteilen erfindungsgemäß Schutzkleidung umfassend eine erfindungsgemäße Vorrichtung vorgesehen. Bei der Schutzkleidung kann es sich z.B. um eine Jacke, ein Hemd oder eine Hose handeln.

Im Falle des erfindungsgemäßen Schutzhandschuhs bzw. Schutzstiefels bzw. der erfindungsgemäßen Schutzkleidung, können das Sensormodul, die Lichtzuführmittel und Lichtleitmittel sowie das Optoelektronikmodul in einem einzigen Bauteil integriert sein, das platzsparend an einem konventionellen Handschuh bzw. Stiefel bzw. einer konventionellen Kleidung befestigt werden kann, um den erfindungsgemäßen Schutzhandschuh bzw. Schutzstiefel bzw. die erfindungsgemäße Schutzkleidung herzustellen.

Weitere Anwendungsmöglichkeiten der erfindungsgemäßen Vorrichtung ergeben sich z.B. zur Warnung vor kritischen elektrischen Feldstärken im ESD-Schutz (ESD: "electrostatic discharge"), insbesondere zum Schutz elektronischer Komponenten und/oder zum Schutz vor Staub- und Gasexplosionen.

Selbstverständlich erlaubt die erfindungsgemäße Vorrichtung ganz allgemein berührungslose, kontaktfreie Potential- oder Spannungsmessungen.

Insbesondere können mittels der erfindungsgemäßen Vorrichtung Feldmessungen in der Atmosphäre vorgenommen werden, z.B. in Gewitterwolken für Wetterprognosen. Damit einher geht die Ermöglichung einer Gefahrenabschätzung, was beispielsweise den Einsatz für Flughäfen besonders interessant macht.

### KURZE BESCHREIBUNG DER FIGUREN

Die Erfindung wird nun anhand von Ausführungsbeispielen näher erläutert. Die Zeichnungen sind beispielhaft und sollen den Erfindungsgedanken zwar darlegen, ihn aber keinesfalls einengen oder gar abschließend wiedergeben.

Dabei zeigt:
- Fig. 1: eine mikromechanische Struktur einer ersten Ausführungsform der erfindungsgemäßen Vorrichtung in Aufsicht
- Fig. 2: die mikromechanische Struktur einer zweiten Ausführungsform der erfindungsgemäßen Vorrichtung in Aufsicht, wobei gegenüber der ersten Ausführungsform ein Verstärkungselement vorgesehen ist
- Fig. 3: eine axonometrische Ansicht der mikromechanischen Struktur aus Fig. 2
- Fig. 4: eine Darstellung analog zu Fig. 3, wobei ein Glas-Wafer mit einer auf seiner Unterseite aufgebrachten strukturierten Metallschicht über der mikromechanischen Struktur angeordnet ist
- Fig. 5: eine Darstellung analog zu Fig. 4, wobei aus Klarheitsgründen der Glas-Wafer ausgeblendet und nur die Metallschicht dargestellt ist
- Fig. 6: die mikromechanische Struktur der zweiten Ausführungsform der erfindungsgemäßen Vorrichtung mit darüber angeordnetem Glas-Wafer in Seitenansicht
- Fig. 7: eine Schnittansicht gemäß einer Schnittlinie A-A in Fig. 4, wobei die Blickrichtung eine zweite Richtung ist
- Fig. 8: eine Darstellung analog zu Fig. 6, wobei zusätzlich eine über dem Glas-Wafer angeordnete Leuchtdiode sowie eine unter der mikromechanischen Struktur angeordnete Photodiode abgebildet sind
- Fig. 9: die mikromechanische Struktur einer dritten Ausführungsform der erfindungsgemäßen Vorrichtung in Aufsicht, wobei gegenüber der zweiten Ausführungsform ein weiterer beweglicher Abschnitt vorgesehen ist
- Fig. 10: die mikromechanische Struktur einer vierten Ausführungsform der erfindungsgemäßen Vorrichtung in Aufsicht, wobei ein elektrisches Feld eine Rotation des beweglichen Abschnitts bewirkt
- Fig. 11: die mikromechanische Struktur aus Fig. 10 in einer Darstellung analog zu Fig. 5, bei der die auf der Unterseite des Glas-Wafers aufgebrachte Metallschicht abgebildet ist, aus Klarheitsgründen jedoch nicht der Glas-Wafer selbst
- Fig. 12: einen erfindungsgemäßen Schutzhelm als ein Anwendungsbeispiel für die erfindungsgemäße Vorrichtung

### WEGE ZUR AUSFÜHRUNG DER ERFINDUNG

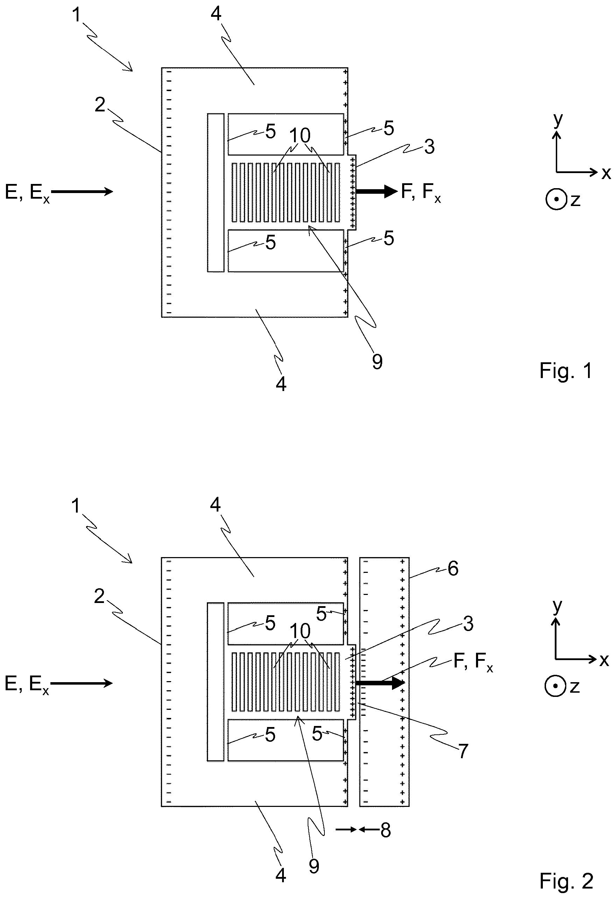

Fig. 1 zeigt eine mikromechanische Struktur 1 einer ersten Ausführungsform der erfindungsgemäßen Vorrichtung zur Messung eines elektrischen Felds E. Die mikromechanische Struktur 1 erstreckt sich in einer ersten Richtung x, einer zweiten Richtung y und einer dritten Richtung z, wobei die erste Richtung x, die zweite Richtung y und die dritte Richtung z wechselseitig normal aufeinander stehen. In der Aufsicht der Fig. 1 ist die mikromechanische Struktur 1 in einer Ebene xy, die parallel zu den Richtungen x, y ist, dargestellt, in welcher Ebene xy die mikromechanische Struktur 1 Abmessungen hat, die typischerweise im Bereich von 0,1 mm bis 5 mm, vorzugsweise von 0,1 mm bis 1 mm, liegen und eine Größenordnung größer sind als in der dritten Richtung z.

Die mikromechanische Struktur 1 ist in allen in den Figuren 1 bis 11 gezeigten Beispielen aus Si gefertigt und vorzugsweise auf Basis eines an sich bekannten Silicon-On-Insulator (SOI)-Wafers hergestellt. D.h. die mikromechanische Struktur 1 besteht aus einem Material, das bei einer Betriebstemperatur, die typischerweise deutlich über dem absoluten Nullpunkt liegt, leitend ist. Insbesondere kann das Si entsprechend dotiert sein, um die Leitfähigkeit für bestimmte Anwendungsfälle bzw. Betriebstemperaturen gezielt einzustellen.

Die mikromechanische Struktur 1 weist im Ausführungsbeispiel der Fig. 1 einen Rahmenabschnitt 2 und einen beweglichen Abschnitt 3 auf, wobei der bewegliche Abschnitt 3 mit dem Rahmenabschnitt 2 elektrisch leitend und mechanisch elastisch verbunden ist und relativ zum Rahmenabschnitt 2 bewegbar ist. Konkret ist dabei der Rahmenabschnitt 2 in der in Fig. 1 gezeigten Ebene U-förmig ausgeführt, wobei sich zwei parallele Schenkel 4 der U-Form parallel zu der ersten Richtung x erstrecken. Der bewegliche Abschnitt 3 ist zwischen diesen Schenkeln 4 angeordnet und über Stege 5, die im Wesentlichen parallel zur zweiten Richtung y verlaufen, mit den Schenkeln 4 verbunden. Der Rahmenabschnitt 2 und der bewegliche Abschnitt 3 sind dabei einstückig ausgeführt. Im gezeigten Beispiel der Fig. 1 sind vier Stege 5 vorgesehen, die im Bereich der vier Ecken des beweglichen Abschnitts 3 angeordnet sind, wobei der bewegliche Abschnitt in der Ebene xy im Wesentlichen einen rechteckigen Umriss hat mit einer größeren Erstreckung in der ersten Richtung x als in der zweiten Richtung y. In der ersten Richtung x überragt der bewegliche Abschnitt 3 den Rahmenabschnitt 2.

Durch das Design der Stege 5 lässt sich die mechanische Ankopplung des beweglichen Abschnitts 3 an den Rahmenabschnitt 2 gezielt beeinflussen. Die Stege 5 können insbesondere in der Ebene xy U-förmig oder mäanderförmig verlaufen (nicht dargestellt), um mechanische Nichtlinearitäten bei größeren Auslenkungen / Anordnungsänderungen des beweglichen Abschnitts 3 parallel zur ersten Richtung x zu vermeiden.

Die mikromechanische Struktur 1 ist so ausgelegt, dass bei einer Anordnung der mikromechanischen Struktur 1 im elektrischen Feld E mit einer ersten Feldstärkenkomponente Eₓ parallel zur ersten Richtung x ungleich null eine elektrische Polarisation der mikromechanischen Struktur 1 erfolgt, die in Fig. 1 durch "+" und "-" auf der mikromechanischen Struktur 1 angedeutet ist. In Fig. 1 ist nur die erste Feldstärkenkomponente Eₓ eingezeichnet bzw. der Fall illustriert, wo Feldstärkenkomponenten in den Richtungen y, z null sind.

Die Polarisation hat eine auf den beweglichen Abschnitt 3 wirkende Kraft F mit einer ersten Kraftkomponente Fₓ parallel zur ersten Richtung x ungleich null zur Folge. Kraftkomponenten in den Richtungen y, z sind im gezeigten Beispiel null.

Durch die erste Kraftkomponente Fₓ kommt es in Abhängigkeit von deren Größe zu einer Änderung (nicht dargestellt) der räumlichen Anordnung des beweglichen Abschnitts 3 relativ zum Rahmenabschnitt 2. Diese Änderung wäre im gezeigten Beispiel eine Auslenkung des beweglichen Abschnitts 3 entlang der ersten Richtung x, vom Rahmenabschnitt 2 weg weisend.

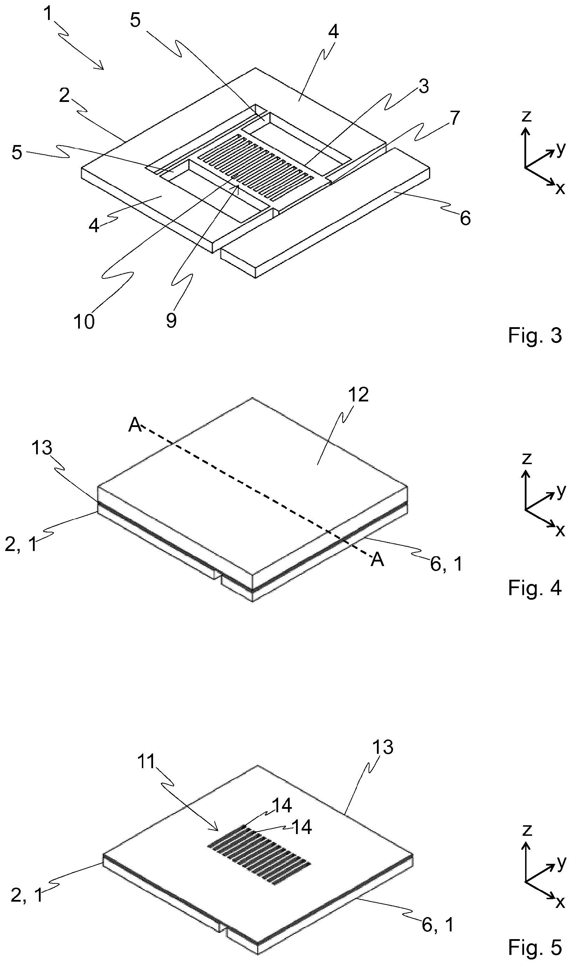

Die bei einer bestimmten ersten Feldstärkenkomponente Eₓ resultierende erste Kraftkomponente Fₓ kann mittels eines Verstärkungselements 6 der mikromechanischen Struktur 1 vergrößert bzw. verstärkt werden, wie es die in Fig. 2 und Fig. 3 gezeigte mikromechanische Struktur 1 einer zweiten Ausführungsform der erfindungsgemäßen Vorrichtung aufweist. Das Verstärkungselement 6 ist in der ersten Richtung x gesehen hinter dem beweglichen Abschnitt 3 angeordnet. Zwischen dem beweglichen Abschnitt 3 und dem Verstärkungselement 6 wiederum ist ein Spalt 7 angeordnet. Letzterer weist im gezeigten Ausführungsbeispiel eine in der ersten Richtung x gemessen Spaltbreite 8 im Bereich 10 µm bis 50 µm auf.

Das Verstärkungselement 6 wird durch das elektrische Feld E bzw. durch die erste Feldstärkenkomponente Eₓ ebenfalls polarisiert, was in Fig. 2 wiederum durch "+" und "-" angedeutet ist. Die Ladungsträger können dabei vom Verstärkungselement 6 nicht zum Rahmenabschnitt 2 oder gar zum beweglichen Abschnitt 3 abfließen. Der bewegliche Abschnitt 3 hat daher im Bereich des Spalts 7 eine genau entgegengesetzte Polarisation wie das Verstärkungselement 6 im Bereich des Spalts 7. Entsprechend wird der bewegliche Abschnitt 3 verstärkt zum Verstärkungselement 6 gezogen bzw. bewirkt das Verstärkungselement 6 eine Verstärkung der ersten Kraftkomponente Fₓ.

Mit Detektionsmitteln kann die Auslenkung/Anordnungsänderung des beweglichen Abschnitts 3 festgestellt und sodann auf die Größe der ersten Feldstärkenkomponente Eₓ geschlossen werden.

In den gezeigten Ausführungsbeispielen erfolgt die Detektion der Auslenkung/Anordnungsänderung des beweglichen Abschnitts 3 optisch, um eine Verzerrung des elektrischen Felds E möglichst zu vermeiden. Um hierbei die Messgenauigkeit zu erhöhen, weist der bewegliche Abschnitt 3 eine Blendenstruktur 9 auf, die aus einer Reihe von rechteckigen Löchern 10 besteht, wobei die Seiten der Rechtecke parallel zu den Richtungen x, y verlaufen. Die Löcher 10 sind gleich groß und in der ersten Richtung x hintereinander angeordnet. Jedes Loch 10 hat in der ersten Richtung x eine wesentlich kleinere Ausdehnung als in der zweiten Richtung y.

Theoretisch kann die durch die Blendenstruktur 9 hervorgerufene Modulation eines entlang der dritten Richtung z auf den beweglichen Abschnitt 3 fallenden Lichts zur Messung der Auslenkung/Anordnungsänderung des beweglichen Abschnitts 3 benutzt werden. In den gezeigten Ausführungsbeispielen ist jedoch zusätzlich eine über dem beweglichen Abschnitt 3 angeordnete, fixe Blendenstruktur 11 vorgesehen, die auf die Blendenstruktur 9 abgestimmt ist. Fig. 5 zeigt die fixe Blendenstruktur 11 für das zweite Ausführungsbeispiel der erfindungsgemäßen Vorrichtung, die aus rechteckigen Metallstreifen 14 besteht, welche Metallstreifen 14 an Anzahl und Größe mit den Löchern 10 übereinstimmen. Die fixe Blendenstruktur 11 ist in den gezeigten Ausführungsbeispielen durch eine Metallschicht 13 auf einer Unterseite eines über der mikromechanischen Struktur 1 angeordneten Glas-Wafers 12 ausgebildet, vgl. Fig. 4. Der Glas-Wafer 12 und damit die fixe Blendenstruktur 11 sind räumlich relativ zum Rahmenabschnitt 2 fixiert.

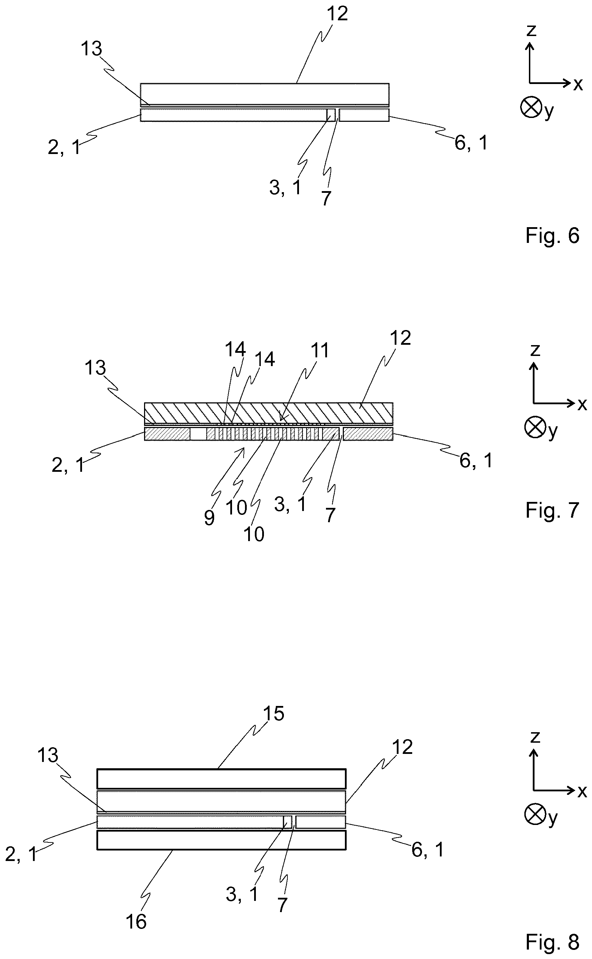

Fig. 6 zeigt eine Seitenansicht entlang der zweiten Richtung y, aus der die Abfolge von beweglichem Abschnitt 3, Metallschicht 13 (und damit fixe Blendenstruktur 11) und Glas-Wafer 12 entlang der dritten Richtung z hervorgeht.

Fig. 7 zeigt eine korrespondierende Schnittansicht entlang der zweiten Richtung y, wobei die Schnittebene durch die strichlierte Linie A-A in Fig. 4 geht. In der Schnittansicht ist die Blendenstruktur 9 mit den Löchern 10 zu erkennen sowie die über den Löchern 10 angeordneten Metallstreifen 14 der fixen Blendenstruktur 11.

Fig. 8 zeigt eine Seitenansicht entlang der zweiten Richtung y, wobei als Detektionsmittel eine Leuchtdiode 15 als Lichtzuführmittel sowie eine Photodiode 16 als optischer Sensor dargestellt sind. Die sich ergebende sehr kompakte Ausführung der erfindungsgemäßen Vorrichtung ist sofort ersichtlich.

Die Leuchtdiode 15 dient dazu, Licht entlang der dritten Richtung z der fixen Blende 11 und dem darunter liegenden beweglichen Abschnitt 3 mit der Blendenstruktur 9 zuzuführen. Die Photodiode 16 detektiert die Intensität des durch die Blendenstrukturen 9, 11 transmittierten Lichts. Aufgrund der geometrischen Auslegung bzw. Abstimmung der Blendenstrukturen 9, 11 haben kleinste Auslenkungen/Anordnungsänderungen des beweglichen Abschnitts 3 deutliche, leicht detektierbare Intensitätsänderungen zur Folge, was eine kostengünstige Herstellung der erfindungsgemäßen Vorrichtung erlaubt.

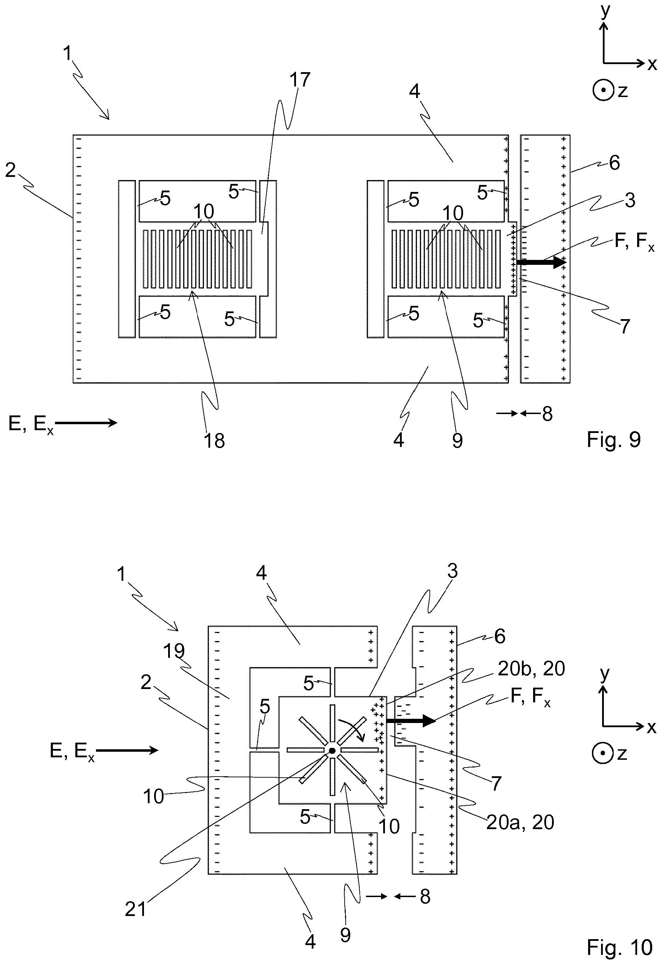

Fig. 9 zeigt die mikromechanische Struktur 1 einer dritten Ausführungsform der erfindungsgemäßen Vorrichtung. Hierbei ist ein weiterer beweglicher Abschnitt 17 vorgesehen, der prinzipiell völlig gleich wie der bewegliche Abschnitt 3 aufgebaut und wie dieser über (im gezeigten Beispiel vier) Stege 5 mit dem Rahmenabschnitt 2 verbunden ist, sodass der weitere bewegliche Abschnitt 17 relativ zum Rahmenabschnitt 2 bewegbar ist. D.h. der weitere bewegliche Abschnitt 17 ist wie der bewegliche Abschnitt 3 mit dem Rahmenabschnitt 2 elektrisch verbunden und an diesen mechanisch elastisch angekoppelt, wobei das Verhältnis der Stärke der mechanischen Ankopplung 1:1 ist. Folglich bewirken Vibrationen der mikromechanischen Struktur 1, welche Vibrationen typischerweise ausschließlich translatorisch wirken, gleichstarke Auslenkungen/Anordnungsänderungen des beweglichen Abschnitts 3 und des weiteren beweglichen Abschnitts 17.

Im Gegensatz zum beweglichen Abschnitt 3 ist der weitere bewegliche Abschnitt 17 jedoch in erster Richtung x gesehen vor dem beweglichen Abschnitt 3 angeordnet. Insbesondere ist das Verstärkungselement 6 sehr weit vom weiteren beweglichen Abschnitt 17 entfernt. Die im elektrischen Feld E mit der ersten Feldstärkenkomponente Eₓ sich ergebende Polarisation der mikromechanischen Struktur 1 bewirkt daher eine um mindestens eine Größenordnung kleinere weitere erste Kraftkomponente, die auf den weiteren beweglichen Abschnitt 17 wirkt, im Vergleich zur ersten Kraftkomponente Fₓ, die auf den beweglichen Abschnitt 3 wirkt. Die weitere erste Kraftkomponente ist im gezeigten Ausführungsbeispiel so klein, dass diese gar nicht eingezeichnet ist.

Eine Auslenkung/Anordnungsänderung des weiteren beweglichen Abschnitts 17 wird daher in erster Linie durch die Vibrationen hervorgerufen. Indem diese Auslenkung bestimmt wird und von der bestimmten/detektierten Auslenkung des beweglichen Abschnitts 3 abgezogen wird, kann unmittelbar auf jenen Anteil an der bestimmten/detektierten Auslenkung des beweglichen Abschnitts 3 geschlossen werden, der auf das elektrische Feld E bzw. auf die erste Feldstärkenkomponente Eₓ zurückgeht.

Zur Bestimmung/Detektion der Auslenkung/Anordnungsänderung des weiteren beweglichen Abschnitts 17 werden weitere Detektionsmittel verwendet, die im Wesentlichen die gleichen Detektionsmittel wie für die Bestimmung/Detektion der Auslenkung/Anordnungsänderung des beweglichen Abschnitts 3 sein können, weshalb an dieser Stelle nicht im Detail auf die weiteren Detektionsmittel eingegangen werden soll, sondern an die obigen Ausführungen betreffend die Detektionsmitteln verwiesen wird. Es sei jedoch erwähnt, dass, wie aus Fig. 9 hervorgeht, der weitere bewegliche Abschnitt 17 eine weitere Blendenstruktur 18 aufweist, die im gezeigten Beispiel exakt gleich wie die Blendenstruktur 9 aufgebaut ist. Entsprechend kann auch eine weitere fixe Blendenstruktur (nicht dargestellt) in der Metallschicht 13 auf der Unterseite des Glas-Wafers 12, der beide Abschnitte 3, 17 überdeckt, vorgesehen sein.

Die Abschnitte 3, 17 (bzw. die fixe Blendenstruktur 11, die weitere fixe Blendenstruktur sowie die darunter liegenden Blendenstrukturen 9, 18) können weiters mit derselben Leuchtdiode 15 beleuchtet werden.

Das transmittierte Licht kann von zwei optischen Sensoren / Photodioden (nicht dargestellt) detektiert werden bzw. von einem optischen Sensor, der unter den Abschnitten 3, 17 angeordnet ist und die beiden Abschnitte 3, 17 räumlich auflöst. D.h. es genügt ein Sensor mit zwei Pixeln, wobei ein Pixel unter dem beweglichen Abschnitt 3 angeordnet ist und ein Pixel unter dem weiteren beweglichen Abschnitt 17.

In Fig. 10 ist die mikromechanische Struktur 1 einer vierten Ausführungsform der erfindungsgemäßen Vorrichtung dargestellt, die ebenfalls die eindeutige Messung des elektrischen Felds E bzw. der ersten Feldstärkenkomponente Eₓ bei Vorliegen von Vibrationen erlaubt. Hierbei wird ausgenutzt, dass Vibrationen typischerweise rein translatorisch wirken. Die mikromechanische Struktur 1 ist nun so ausgelegt, dass die durch die erste Feldstärkenkomponente Eₓ hervorgerufene Änderung der räumlichen Anordnung des beweglichen Abschnitts 3 relativ zum Rahmenabschnitt 2 eine Rotation des beweglichen Abschnitts 3 relativ zum Rahmenabschnitt 2 - im gezeigten Beispiel um eine zur dritten Richtung z parallele Rotationsachse - ist. Indem gezielt die rotatorische Anordnungsänderung bestimmt wird, kann direkt auf die erste Feldstärkenkomponente Eₓ geschlossen werden.

Der bewegliche Abschnitt 3 ist hierzu wiederum im U-förmigen Rahmenabschnitt 2 angeordnet, wobei der bewegliche Abschnitt 3 einen im Wesentlichen quadratischen Umriss mit Seiten in der Ebene xy hat. Der bewegliche Abschnitt ist über drei Stege 5 sowohl mit den Schenkeln 4 als auch mit einem die Schenkel 4 verbindenden Querbalken 19 des Rahmenabschnitts 2 verbunden. Die Stege 5 sind dabei jeweils mittig bezogen auf die Seiten des beweglichen Abschnitts 3 angeordnet. Eine nicht mit dem Rahmenabschnitt 2 verbundene Seite 20 des beweglichen Abschnitts 3 ragt in der ersten Richtung x über den Rahmenabschnitt 2 hinaus. Die Seite 20 verläuft parallel zur zweiten Richtung y und weist in der zweiten Richtung y gesehen eine erste Hälfte 20a und eine darauffolgende zweite Hälfte 20b auf.

In der ersten Richtung x gesehen ist hinter der Seite 20 das Verstärkungselement 6 angeordnet, welches jedoch im Gegensatz zum Ausführungsbeispiel der Fig. 2 speziell geformt ist. Diese Form ist so, dass das Verstärkungselement 6 der Seite 20 nur im Bereich der zweiten Hälfte 20b nahekommt. D.h. Spalt 7 mit der Spaltbreite 8 ist nur im Bereich der zweiten Hälfte 20b vorhanden. Entsprechend wird durch das Verstärkungselement 6 nur im Bereich der zweiten Hälfte 20b eine verstärkte erste Kraftkomponente Fx erzeugt bzw. greift diese verstärkte Kraftkomponente Fx nur im Bereich der zweiten Hälfte 20b am beweglichen Abschnitt 3 an, nicht jedoch im Bereich der ersten Hälfte 20a. Die Folge ist eine Rotation des beweglichen Abschnitts um eine Rotationsachse 21, die im Zentrum des beweglichen Abschnitts 3 bezogen auf die Ebene xy liegt, welche Rotation in Fig. 10 durch den gekrümmten Pfeil angedeutet ist. Die Rotationsachse 21 steht normal auf die Ebene xy.

Um gezielt den rotatorischen und nicht den translatorischen Anteil an der Auslenkung/Anordnungsänderung des beweglichen Abschnitts 3 detektieren zu können, ist die Blendenstruktur 9 entsprechend adaptiert. Konkret weist die Blendenstruktur 9 hierzu wiederum eine Vielzahl von rechteckigen Löchern 10 auf, die jedoch sternförmig rund um das Zentrum des beweglichen Abschnitts 3 bezogen auf die Ebene xy bzw. rund um die Rotationsachse 21 angeordnet sind. Mit anderen Worten sind die rechteckigen Löcher 10 rund um die Rotationsachse 21 und mit ihren längeren Seiten radial nach außen weisend angeordnet.

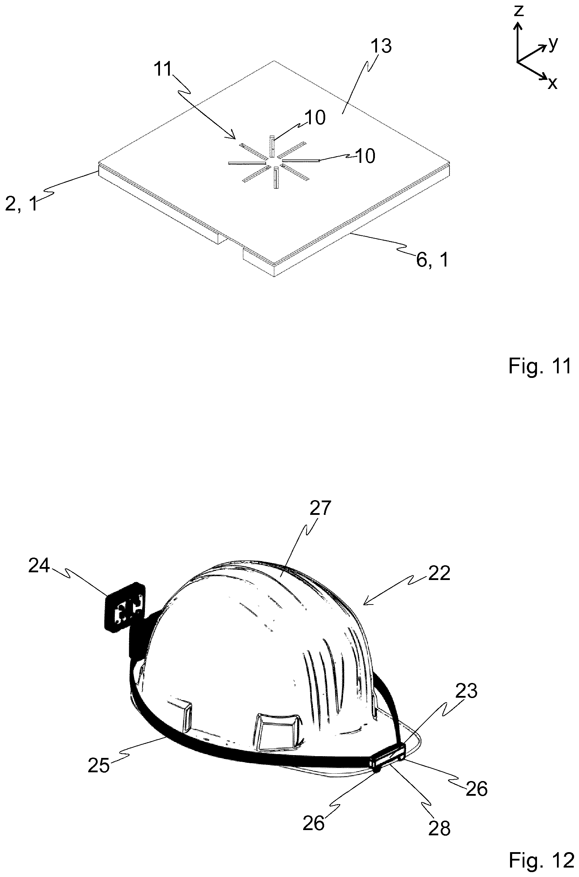

Entsprechend ist auch die fixe Blendenstruktur 11 angepasst, vgl. Fig. 11. Die Blendenstruktur 11 ist wiederum durch die Metallschicht 13 ausgebildet und besteht nun jedoch aus rechteckigen Löchern 10 in der Metallschicht, die gleich groß und gleich orientiert zu den rechteckigen Löchern 10 der Blendenstruktur 9 sind.

Der sonstige Aufbau mit Leuchtdiode 15 und Photodiode 16 entspricht dem in Fig. 8 gezeigten. Wenn nun Licht von der Leuchtdiode 15 durch die Blendenstrukturen 11 und 9 transmittiert wird, hängt die Intensität des transmittierten und von der Photodiode 16 detektierten Lichts wesentlich stärker von der rotatorischen Anordnung der Blendenstrukturen 11 und 9 zueinander ab als von deren translatorischen Anordnung zueinander. Translatorische Auslenkungen/Anordnungsänderungen sind somit für diese Intensitätsmessungen vernachlässigbar, und die gemessene Intensitätsänderung ist im Wesentlichen ein Maß für die rotatorische Auslenkung/Anordnungsänderung des beweglichen Abschnitts 3 relativ zum Rahmenabschnitt 2. Entsprechend kann selbst bei Vorliegen von Vibrationen zuverlässig und mit hoher Genauigkeit auf das elektrische Feld E bzw. auf die erste Feldstärkenkomponente Eₓ geschlossen werden.

Fig. 12 zeigt einen erfindungsgemäßen Schutzhelm 22 als ein Anwendungsbeispiel für die erfindungsgemäße Vorrichtung. Der Schutzhelm 22 dient zur Warnung eines Arbeiters vor spannungsführenden Bauteilen. Im dargestellten Ausführungsbeispiel ist die erfindungsgemäße Vorrichtung nicht fix in den Schutzhelm 22 integriert, sondern zur Montage auf einem konventionellen Helm 27 eingerichtet, um den erfindungsgemäßen Schutzhelm 22 mittels des konventionellen Helms 27 auf einfache Art und Weise zu verwirklichen. Dies hat den Vorteil, dass im Prinzip ein beliebiger Helm 27 verwendet werden kann und der Helm 27 bei Bedarf auch ausgetauscht werden kann.

Im gezeigten Ausführungsbeispiel ist die mikromechanische Struktur 1 in einem Sensormodul 23 angeordnet. Das Sensormodul 23 ist insofern an die Form des Helms 27 angepasst, als das Sensormodul 23 Haken 26 aufweist, welche zum Umgreifen eines Rands 28 des Helms 27 dienen. Wie in Fig. 12 dargestellt, sind die Haken 26 bzw. ist das Sensormodul 23 dabei in einem vorderen Abschnitt des Helms 27 angeordnet, d.h. in einem Bereich, der beim Tragen des Helms 27 nahe der Stirn eines Benutzers angeordnet ist.

Das Sensormodul 23 ist über ein elastisches Band 25 mit einem Optoelektronikmodul 24 verbunden, wobei das Sensormodul 23 gemeinsam mit dem Optoelektronikmodul 24 und dem Band 25 zur Befestigung am Helm 27 über diesen gestülpt bzw. gespannt ist. Das Band 25 weist Lichtzuführmittel und Lichtleitmittel in Form von Glasfasern auf. Mittels mindestens einer Glasfaser als Lichtzuführmittel kann Licht, das im Optoelektronikmodul 24 beispielsweise mittels einer nicht extra dargestellten Leucht- oder Laserdiode erzeugt wird, der mikromechanischen Struktur 1 auf einer Seite zugeführt werden.

Mindestens eine Glasfaser des Bands 25 ist als Lichtleitmittel Teil eines optischen Sensors, der im dargestellten Ausführungsbeispiel weiters eine im Optoelektronikmodul 24 angeordnete Photodiode (nicht dargestellt) umfasst. Licht auf der gegenüberliegenden Seite der mikromechanischen Struktur 1 wird mit dieser mindestens einen Glasfaser aufgefangen und der Photodiode zugeführt.

Das Optoelektronikmodul 24 umfasst weiters eine entsprechende Auswerteelektronik. Bei Detektion eines elektrischen Felds, das für den Arbeiter bzw. Benutzer gefährlich sein kann, gibt das Optoelektronikmodul 24 optische und/oder akustische Warnsignale aus, um den Arbeiter bzw. Benutzer zu warnen.

### BEZUGSZEICHENLISTE

- 1: Mikromechanische Struktur
- 2: Rahmenabschnitt
- 3: Beweglicher Abschnitt
- 4: Schenkel
- 5: Steg
- 6: Verstärkungselement
- 7: Spalt
- 8: Spaltbreite
- 9: Blendenstruktur am beweglichen Abschnitt
- 10: Rechteckiges Loch
- 11: Fixe Blendenstruktur
- 12: Glas-Wafer
- 13: Metallschicht
- 14: Metallstreifen
- 15: Leuchtdiode
- 16: Photodiode
- 17: Weiterer beweglicher Abschnitt
- 18: Weitere Blendenstruktur am weiteren beweglichen Abschnitt
- 19: Querbalken
- 20: Nicht verbundene Seite des beweglichen Abschnitts
- 20a: Erste Hälfte der Seite 20
- 20b: Zweite Hälfte der Seite 20
- 21: Rotationsachse
- 22: Schutzhelm
- 23: Sensormodul
- 24: Optoelektronikmodul
- 25: Band mit mindestens einer integrierten Glasfaser
- 26: Haken
- 27: Helm
- 28: Rand des Helms
- x: Erste Richtung
- y: Zweite Richtung
- z: Dritte Richtung
- xy: Ebene, parallel zur ersten und zweiten Richtung
- E: Elektrisches Feld
- Eₓ: Erste Feldstärkenkomponente des elektrischen Felds parallel zur ersten Richtung
- F: Kraft
- Fₓ: Erste Kraftkomponente parallel zur ersten Richtung

## Patentansprüche

1. Vorrichtung zur Messung eines elektrischen Felds (E), die Vorrichtung umfassend eine mikromechanische Struktur (1), welche sich in einer ersten Richtung (x), einer zweiten Richtung (y) und einer dritten Richtung (z) erstreckt,
wobei die erste Richtung (x), die zweite Richtung (y) und die dritte Richtung (z) wechselseitig normal aufeinander stehen, **dadurch gekennzeichnet, dass**
die mikromechanische Struktur (1) aus einem bei einer Betriebstemperatur elektrisch leitenden Material gefertigt ist und einen Rahmenabschnitt (2) sowie einen beweglichen Abschnitt (3) aufweist,
wobei der bewegliche Abschnitt (3) mit dem Rahmenabschnitt (2) elektrisch leitend und mechanisch elastisch verbunden ist und relativ zum Rahmenabschnitt (2) bewegbar ist,
wobei die mikromechanische Struktur (1) so ausgelegt ist, dass bei einer Anordnung der mikromechanischen Struktur (1) im elektrischen Feld (E) mit einer ersten Feldstärkenkomponente (Eₓ) parallel zur ersten Richtung (x) ungleich null eine elektrische Polarisation der mikromechanischen Struktur (1) erfolgt, die eine auf den beweglichen Abschnitt (3) wirkende erste Kraftkomponente (Fₓ) parallel zur ersten Richtung (x) sowie eine von der ersten Kraftkomponente (Fₓ) abhängige Änderung der räumlichen Anordnung des beweglichen Abschnitts (3) relativ zum Rahmenabschnitt (2) zur Folge hat,
und wobei Detektionsmittel (9, 11, 15, 16) vorgesehen sind, um die Änderung der räumlichen Anordnung des beweglichen Abschnitts (3) relativ zum Rahmenabschnitt (2) zu bestimmen.

2. Vorrichtung nach Anspruch 1, **dadurch gekennzeichnet, dass** der Rahmenabschnitt (2) und der bewegliche Abschnitt (3) einstückig ausgebildet sind.

3. Vorrichtung nach einem der Ansprüche 1 bis 2, **dadurch gekennzeichnet, dass** der Rahmenabschnitt (2) in einer Ebene (xy), die parallel zu der ersten Richtung (x) und der zweiten Richtung (y) ist, zumindest abschnittsweise im Wesentlichen eine U-Form ausbildet, wobei parallele Schenkel (4) der U-Form parallel zur ersten Richtung (x) verlaufen, dass der bewegliche Abschnitt (3) zwischen den Schenkeln (4) angeordnet ist und dass der bewegliche Abschnitt (3) über Stege (5), die vorzugsweise parallel zur zweiten Richtung (y) verlaufen, mit den Schenkeln (4) verbunden ist.

4. Vorrichtung nach einem der Ansprüche 1 bis 3, **dadurch gekennzeichnet, dass** die mikromechanische Struktur (1) ein vom Rahmenabschnitt (2) und vom beweglichen Abschnitt (3) elektrisch separates Verstärkungselement (6) umfasst, welches in der ersten Richtung (x) gesehen hinter dem beweglichen Abschnitt (3) angeordnet ist, wobei zwischen dem beweglichen Abschnitt (3) und dem Verstärkungselement (6) ein Spalt (7) angeordnet ist.

5. Vorrichtung nach Anspruch 4, **dadurch gekennzeichnet, dass** der Spalt (7) eine in der ersten Richtung (x) gemessene Spaltbreite (8) kleiner gleich 500 µm, bevorzugt kleiner gleich 200 µm, besonders bevorzugt von 0,1 µm bis 50 µm, aufweist.

6. Vorrichtung nach einem der Ansprüche 1 bis 5, **dadurch gekennzeichnet, dass** die Detektionsmittel einen optischen Sensor (16) sowie mindestens ein Lichtzuführmittel (15) umfassen.

7. Vorrichtung nach Anspruch 6, **dadurch gekennzeichnet, dass** der bewegliche Abschnitt (3) zwischen dem mindestens einen Lichtzuführmittel (15) und dem optischen Sensor (16) angeordnet ist.

8. Vorrichtung nach Anspruch 7, **dadurch gekennzeichnet, dass** das mindestens eine Lichtzuführmittel einen Lichtleiter umfasst, um eine Seite der mikromechanischen Struktur (1) zumindest abschnittsweise mit durch den Lichtleiter geleiteten Licht zu beleuchten, und dass der optische Sensor einen weiteren Lichtleiter umfasst, um das Licht auf einer gegenüberliegenden Seite der mikromechanischen Struktur (1) aufzufangen.

9. Vorrichtung nach einem der Ansprüche 1 bis 8, **dadurch gekennzeichnet, dass** die Detektionsmittel eine Blendenstruktur (9) am beweglichen Abschnitt (3) sowie eine fixe Blendenstruktur (11) umfassen, wobei die fixe Blendenstruktur (11) eine relativ zum Rahmenabschnitt (2) fixe räumliche Anordnung aufweist, wobei die fixe Blendenstruktur (11) vorzugsweise in einer Metallschicht (13) auf einem Glas-Wafer (12) ausgebildet ist.

10. Vorrichtung nach Anspruch 9 und nach Anspruch 7, **dadurch gekennzeichnet, dass** die fixe Blendenstruktur (11) zwischen dem beweglichen Abschnitt (3), insbesondere der Blendenstruktur (9) am beweglichen Abschnitt (3), und dem mindestens einen Lichtzuführmittel (15) oder dem optischen Sensor (16) angeordnet ist.

11. Vorrichtung nach einem der Ansprüche 1 bis 9, **dadurch gekennzeichnet, dass** die mikromechanische Struktur (1) so ausgelegt ist, dass die Änderung der räumlichen Anordnung des beweglichen Abschnitts (3) relativ zum Rahmenabschnitt (2) eine Rotation des beweglichen Abschnitts (3) relativ zum Rahmenabschnitt (2), vorzugsweise um eine zur dritten Richtung (z) parallele Rotationsachse, umfasst.

12. Vorrichtung nach einem der Ansprüche 1 bis 11, **dadurch gekennzeichnet, dass** die mikromechanische Struktur (1) einen weiteren beweglichen Abschnitt (17) umfasst, der mit dem Rahmenabschnitt (2) elektrisch leitend und mechanisch elastisch verbunden ist, wobei die Stärke der mechanischen Ankopplung des weiteren beweglichen Abschnitts (17) an den Rahmenabschnitt (2) in einem bestimmten bekannten Verhältnis, vorzugsweise im Verhältnis 1:1, zur Stärke der mechanischen Ankopplung des beweglichen Abschnitts (3) an den Rahmenabschnitt (2) steht, und wobei die mikromechanische Struktur (1) so ausgelegt ist, dass bei einer Anordnung der mikromechanischen Struktur (1) im elektrischen Feld (E) mit der ersten Feldstärkenkomponente (Eₓ) ungleich null die elektrische Polarisation der mikromechanischen Struktur (1) erfolgt, die eine auf den weiteren beweglichen Abschnitt (17) wirkende weitere erste Kraftkomponente parallel zur ersten Richtung (x) sowie eine von der weiteren ersten Kraftkomponente abhängige Änderung der räumlichen Anordnung des weiteren beweglichen Abschnitts (17) relativ zum Rahmenabschnitt (2) zur Folge hat, wobei die weitere erste Kraftkomponente und/oder die Änderung der räumlichen Anordnung des weiteren beweglichen Abschnitts (17) um einen Faktor kleiner gleich 0,1, vorzugsweise kleiner gleich 0,01, kleiner ist als die erste Kraftkomponente und/oder die von der ersten Kraftkomponente hervorgerufene Änderung der räumlichen Anordnung des beweglichen Abschnitts (3),
und dass weitere Detektionsmittel (18) vorgesehen sind, um die Änderung der räumlichen Anordnung des weiteren beweglichen Abschnitts (17) relativ zum Rahmenabschnitt (2) zu bestimmen.

13. Vorrichtung nach Anspruch 12, **dadurch gekennzeichnet, dass** die weiteren Detektionsmittel eine weitere Blendenstruktur (18) am weiteren beweglichen Abschnitt (17) sowie eine weitere fixe Blendenstruktur umfassen, wobei die weitere fixe Blendenstruktur (11) eine relativ zum Rahmenabschnitt (2) fixe räumliche Anordnung aufweist, und dass vorzugsweise die weitere fixe Blendenstruktur (11) in einer Metallschicht (13) auf einem Glas-Wafer (12) ausgebildet ist.

14. Vorrichtung nach einem der Ansprüche 12 bis 13, **dadurch gekennzeichnet, dass** die weiteren Detektionsmittel einen weiteren optischen Sensor sowie mindestens ein weiteres Lichtzuführmittel umfassen.

15. Vorrichtung nach Anspruch 14 und nach Anspruch 7, **dadurch gekennzeichnet, dass** der weitere optische Sensor durch den optischen Sensor (16) und das mindestens eine weitere Lichtzuführmittel durch das mindestens eine Lichtzuführmittel (15) ausgebildet sind, wobei der weitere bewegliche Abschnitt (17) zwischen dem mindestens einen Lichtzuführmittel (15) und dem optischen Sensor (16) angeordnet ist.

## Claims

1. Device for measurement of an electric field (E), the device comprising a micromechanical structure (1), which extends in a first direction (x), a second direction (y) and a third direction (z), wherein the first direction (x), the second direction (y) and the third direction (z) are mutually normal to one another, **characterized in that** the micromechanical structure (1) is made from a material that is electrically conducting at an operating temperature and has a frame portion (2) as well as a movable portion (3),
wherein the movable portion (3) is connected in electrically conducting and mechanically elastic manner with the frame portion (2) and is movable relative to the frame portion (2),
wherein the micromechanical structure (1) is so designed that, in the case of an arrangement of the micromechanical structure (1) in the electric field (E) with a non-zero first field-strength component (Eₓ) parallel to the first direction (x), an electrical polarization of the micromechanical structure (1) takes place, which results in a first force component (Fₓ) acting on the movable portion (3) parallel to the first direction (x) as well as a change, dependent on the first force component (Fₓ), of the spatial arrangement of the movable portion (3) relative to the frame portion (2),
and wherein detecting means (9, 11, 15, 16) are provided, in order to determine the change of the spatial arrangement of the movable portion (3) relative to the frame portion (2).

2. Device according to claim 1, **characterized in that** the frame portion (2) and the movable portion (3) are constructed in one piece.

3. Device according to one of claims 1 to 2, **characterized in that** the frame portion (2) is formed at least partially with substantially a U-shape in a plane (xy) that is parallel to the first direction (x) and the second direction (y), wherein parallel limbs (4) of the U-shape extend parallel to the first direction (x), **in that** the movable portion (3) is disposed between the limbs (4) and **in that** the movable portion (3) is connected with the limbs (4) via webs (5), which preferably extend parallel to the second direction (y).

4. Device according to one of claims 1 to 3, **characterized in that** the micromechanical structure (1) comprises an amplifying element (6) that is electrically separate from the frame portion (2) and from the movable portion (3) and that, viewed in the first direction (x), is disposed behind the movable portion (3), wherein a gap (7) is disposed between the movable portion (3) and the amplifying element (6).

5. Device according to claim 4, **characterized in that** the gap (7) has a gap width (8), measured in the first direction (x), of smaller than or equal to 500 µm, preferably of smaller than or equal to 200 µm, particularly preferably of 0.1 µm to 50 µm.

6. Device according to one of claims 1 to 5, **characterized in that** the detecting means comprise an optical sensor (16) as well as at least one light-supplying means (15).

7. Device according to claim 6, **characterized in that** the movable portion (3) is disposed between the at least one light-supplying means (15) and the optical sensor (16).

8. Device according to claim 7, **characterized in that** the at least one light-supplying means comprises a light guide, in order to illuminate one side of the micromechanical structure (1) at least partly with light guided by the light guide, and **in that** the optical sensor comprises a further light guide, in order to capture the light on an opposite side of the micromechanical structure (1).

9. Device according to one of claims 1 to 8, **characterized in that** the detecting means comprise an aperture structure (9) on the movable portion (3) as well as a fixed aperture structure (11), wherein the fixed aperture structure (11) has a fixed spatial arrangement relative to the frame portion (2), wherein the fixed aperture structure (11) is preferably formed in a metal layer (13) on a glass wafer (12).

10. Device according to claim 9 and according to claim 7, **characterized in that** the fixed aperture structure (11) is disposed between the movable portion (3), especially the aperture structure (9) on the movable portion (3), and the at least one light-supplying means (15) or the optical sensor (16).

11. Device according to one of claims 1 to 9, **characterized in that** the micromechanical structure (1) is so designed that the change of the spatial arrangement of the movable portion (3) relative to the frame portion (2) comprises a rotation of the movable portion (3) relative to the frame portion (2), preferably around an axis of rotation parallel to the third direction (z).

12. Device according to one of claims 1 to 11, **characterized in that** the micromechanical structure (1) comprises a further movable portion (17), which is connected in electrically conducting and mechanically elastic manner with the frame portion (2), wherein the strength of the mechanical coupling of the further movable portion (17) to the frame portion (2) is in a given known ratio, preferably in 1:1 ratio, to the strength of the mechanical coupling of the movable portion (3) to the frame portion (2), and wherein the micromechanical structure (1) is so designed that, in the case of an arrangement of the micromechanical structure (1) in the electric field (E) with the non-zero first field-strength component (Eₓ), the electrical polarization of the micromechanical structure (1) takes place, which results in a further first force component acting on the further movable portion (17) parallel to the first direction (x) as well as a change, dependent on the further first force component, of the spatial arrangement of the further movable portion (17) relative to the frame portion (2), wherein the further first force component and/or the change of the spatial arrangement of the further movable portion (17) is smaller by a factor smaller than or equal to 0.1, preferably smaller than or equal to 0.01, than the first force component and/or the change of the spatial arrangement of the movable portion (3) generated by the first force component,
and **in that** further detecting means (18) are provided, in order to determine the change of the spatial arrangement of the further movable portion (17) relative to the frame portion (2).

13. Device according to claim 12, **characterized in that** the further detecting means comprise a further aperture structure (18) on the further movable portion (17) as well as a further fixed aperture structure, wherein the further fixed aperture structure (11) has a fixed spatial arrangement relative to the frame portion (2), and **in that** the further fixed aperture structure (11) is preferably formed in a metal layer (13) on a glass wafer (12) .

14. Device according to one of claims 12 to 13, **characterized in that** the further detecting means comprise a further optical sensor as well as at least one further light-supplying means.

15. Device according to claim 14 and according to claim 7, **characterized in that** the further optical sensor is formed by the optical sensor (16) and the at least one further light-supplying means is formed by the at least one light-supplying means (15), wherein the further movable portion (17) is disposed between the at least one light-supplying means (15) and the optical sensor (16).

## Revendications

1. Dispositif pour mesurer un champ électrique (E), le dispositif comprenant une structure micromécanique (1) s'étendant dans une première direction (x), une deuxième direction (y) et une troisième direction (z), la première direction (x), la deuxième direction (y) et la troisième direction (z) étant mutuellement normales l'une par rapport à l'autre, **caractérisé en ce que**
la structure micromécanique (1) est constituée d'un matériau électriquement conducteur à une température de fonctionnement et présente une partie cadre (2) ainsi qu'une partie mobile (3),
dans lequel la partie mobile (3) est reliée de manière électriquement conductrice et mécaniquement élastique à la partie cadre (2) et est mobile par rapport à la partie cadre (2),
dans lequel la structure micromécanique (1) est conçue de telle sorte que, lorsque la structure micromécanique (1) est disposée dans le champ électrique (E) ayant une première composante d'intensité de champ (Eₓ) parallèle à la première direction (x) non égale à zéro, une polarisation électrique de la structure micromécanique (1) a lieu, qui a pour conséquence une première composante de force (Fₓ) agissant sur la partie mobile (3) parallèlement à la première direction (x) ainsi qu'une modification, dépendant de la première composante de force (Fₓ), de la disposition spatiale de la partie mobile (3) par rapport à la partie cadre (2),
et dans lequel des moyens de détection (9, 11, 15, 16) sont prévus pour déterminer la modification de la disposition spatiale de la partie mobile (3) par rapport à la partie cadre (2).

2. Dispositif selon la revendication 1, **caractérisé en ce que** la partie cadre (2) et la partie mobile (3) sont formées d'une seule pièce.

3. Dispositif selon l'une des revendications 1 à 2, **caractérisé en ce que** la partie cadre (2) présente, au moins sur certaines parties, une forme sensiblement en U dans un plan (xy) parallèle à la première direction (x) et à la deuxième direction (y), des branches parallèles (4) de la forme en U s'étendant parallèlement à la première direction (x), que la partie mobile (3) est disposée entre les branches (4) et que la partie mobile (3) est reliée aux branches (4) par des entretoises (5) qui s'étendent de préférence parallèlement à la deuxième direction (y).

4. Dispositif selon l'une des revendications 1 à 3, **caractérisé en ce que** la structure micromécanique (1) comprend un élément de renforcement (6) séparé électriquement de la partie cadre (2) et de la partie mobile (3), lequel est disposé derrière la partie mobile (3) vu dans la première direction (x), une fente (7) étant disposée entre la partie mobile (3) et l'élément de renforcement (6).

5. Dispositif selon la revendication 4, **caractérisé en ce que** la fente (7) présente une largeur de fente (8) mesurée dans la première direction (x) inférieure ou égale à 500 µm, de préférence inférieure ou égale à 200 µm, plus préférentiellement de 0,1 µm à 50 µm.

6. Dispositif selon l'une des revendications 1 à 5, **caractérisé en ce que** les moyens de détection comprennent un capteur optique (16) et au moins un moyen d'amenée de lumière (15).

7. Dispositif selon la revendication 6, **caractérisé en ce que** la partie mobile (3) est disposée entre ledit au moins un moyen d'amenée de lumière (15) et le capteur optique (16).

8. Dispositif selon la revendication 7, **caractérisé en ce que** ledit au moins un moyen d'amenée de lumière comprend un guide de lumière pour éclairer un côté de la structure micromécanique (1) au moins sur certaines parties avec la lumière guidée par le guide de lumière, et que le capteur optique comprend un autre guide de lumière pour capter la lumière sur un côté opposé de la structure micromécanique (1) .

9. Dispositif selon l'une des revendications 1 à 8, **caractérisé en ce que** les moyens de détection comprennent une structure de diaphragme (9) sur la partie mobile (3) ainsi qu'une structure de diaphragme fixe (11), la structure de diaphragme fixe (11) présentant une disposition spatiale fixe par rapport à la partie cadre (2) et la structure de diaphragme fixe (11) étant de préférence formée dans une couche métallique (13) sur une plaquette de verre (12).

10. Dispositif selon la revendication 9 et selon la revendication 7, **caractérisé en ce que** la structure de diaphragme fixe (11) est disposée entre la partie mobile (3), en particulier la structure de diaphragme (9) sur la partie mobile (3), et ledit au moins un moyen d'amenée de lumière (15) ou le capteur optique (16).

11. Dispositif selon l'une des revendications 1 à 9, **caractérisé en ce que** la structure micromécanique (1) est conçue de telle sorte que la modification de la disposition spatiale de la partie mobile (3) par rapport à la partie cadre (2) comprend une rotation de la partie mobile (3) par rapport à la partie cadre (2), de préférence autour d'un axe de rotation parallèle à la troisième direction (z).

12. Dispositif selon l'une des revendications 1 à 11, **caractérisé en ce que** la structure micromécanique (1) comprend une autre partie mobile (17) qui est reliée de manière électriquement conductrice et mécaniquement élastique à la partie cadre (2), dans lequel l'intensité du couplage mécanique de l'autre partie mobile (17) à la partie cadre (2) est dans un certain rapport connu, de préférence dans le rapport 1:1, à l'intensité du couplage mécanique de la partie mobile (3) à la partie cadre (2), et dans lequel la structure micromécanique (1) est conçue de telle sorte que, lorsque la structure micromécanique (1) est disposée dans le champ électrique (E) ayant la première composante d'intensité de champ (Eₓ) non égale à zéro, la polarisation électrique de la structure micromécanique (1) a lieu, qui a pour conséquence une autre première composante de force agissant sur l'autre partie mobile (17) parallèlement à la première direction (x) ainsi qu'une modification, dépendant de l'autre première composante de force, de la disposition spatiale de l'autre partie mobile (17) par rapport à la partie cadre (2), dans lequel l'autre première composante de force et/ou la modification de la disposition spatiale de l'autre partie mobile (17) est inférieure à la première composante de force et/ou à la modification de la disposition spatiale de la partie mobile (3) provoquée par la première composante de force d'un facteur inférieur ou égal à 0,1, de préférence inférieur ou égal à 0,01,
et que d'autres moyens de détection (18) sont prévus pour déterminer la modification de la disposition spatiale de l'autre partie mobile (17) par rapport à la partie cadre (2).

13. Dispositif selon la revendication 12, **caractérisé en ce que** les autres moyens de détection comprennent une autre structure de diaphragme (18) sur l'autre partie mobile (17) et une autre structure de diaphragme fixe, l'autre structure de diaphragme fixe (11) présentant une disposition spatiale fixe par rapport à la partie cadre (2), et que, de préférence, l'autre structure de diaphragme fixe (11) est formée dans une couche métallique (13) sur une plaquette de verre (12).

14. Dispositif selon l'une des revendications 12 à 13, **caractérisé en ce que** les autres moyens de détection comprennent un autre capteur optique et au moins un autre moyen d'amenée de lumière.

15. Dispositif selon la revendication 14 et selon la revendication 7, **caractérisé en ce que** l'autre capteur optique est formé par le capteur optique (16) et ledit au moins un autre moyen d'amenée de lumière par ledit au moins un moyen d'amenée de lumière (15), l'autre partie mobile (17) étant disposée entre ledit au moins un moyen d'amenée de lumière (15) et le capteur optique (16).
